# EUROPEAN PATENT SPECIFICATION

(11) **EP 4 049 085 B1**
(45) Date of publication and mention of the grant of the patent: **28.01.2026**
(21) Application number: 20765452.6
(22) Date of filing: 24.08.2020
(51) Int. Cl.: G02F 1/1333, G02F 1/1335, H04M 1/02, H10K 59/80

(54) **DISPLAYS WITH PASSIVE DISPLAY AREAS**
ANZEIGEN MIT PASSIVEN ANZEIGEBEREICHEN
AFFICHAGES À ZONES D'AFFICHAGE PASSIVES

(43) Date of publication of application: 31.08.2022
(73) Proprietor: Google LLC, Mountain View, CA 94043 (US)
(72) Inventor: CHOI, Sangmoo, Mountain View, California 94043 (US); KARRI, Jyothi, Mountain View, California 94043 (US); MATSUOKA, Yoshimichi, Mountain View, California 94043 (US)
(74) Representative: Marks & Clerk GST
(86) International application number: PCT/US2020/047670
(87) International publication number: WO 2022/046025

(56) References cited:
- US-A1- 2007 070 272
- US-A1- 2008 123 032
- US-A1- 2014 265 822
- US-A1- 2015 301 417
- US-A1- 2017 322 357

## Description

### BACKGROUND

Manufacturers produce display panels and display panel modules for electronic devices (*e.g*., smartphones, wearable computers, tablets) having a layered structure, frequently referred to as a "display panel structure" and as a "display panel stack." Through a manufacturing process, a display cover layer (*e.g*., cover glass, window, film) is bonded to the top of the display panel structure during the manufacture of the electronic device to form the display panel module. Before the display cover layer is bonded to the display panel structure, an opaque border or "bezel" may be added to the underside of the display cover layer. The opaque border acts as a frame, hiding routing circuitry in a non-display area (*e.g*., inactive area, non-emissive area) of the display panel module and surrounding the portion of a display panel of the display panel module visible to a user of the device, such as when a user views content on the active display area (*e.g*., active area, emissive pixel area) of the display panel module.

Conveniently, the opaque border is wide enough to cover the entire inactive area of the display panel module. However, as a result of manufacturing tolerances present in processes utilized to laminate display cover layers to display panel structures, a gap region may exist in the inactive area between the inner edge of the opaque border and the outer edge of the emissive pixels of the active area of the display panel module. For example, a gap region of around 0.4 mm between the inner edge of the opaque border and the outer edge of the pixels of the active area may exist in the inactive area. To a user of the device, this gap region looks like a black rim surrounding the display, located between the edge of the active display area and the edge of the opaque border. In such a configuration, a black-colored opaque border appears seamless (a "seamless bezel") and provides for a more-immersive user experience. In contrast, if the opaque border is a different color (other than black) when a lighter image is displayed on the display, the black-colored gap region is visible to the user, appearing as a black frame around the display, potentially preventing an immersive user experience.

US2007/070272A1 discloses a transflective display in which a border area adjacent to an active area has a reflectivity that is substantially the same as the active area when the display is turned off. This display includes a polarizer layer, a color filter glass (CFG) layer, a liquid crystal layer, and a reflector layer. The CFG layer contains color filters in the active area, while the border area of the CFG layer is designed to have a reflectivity that is substantially the same as the active area when the display is turned off.

US2008/123032A1 discloses a liquid crystal display panel which has: an array substrate with a display region in which a pixel electrode is formed in each of the regions enclosed by a plurality of signal lines and scan lines deployed as matrices; a opposed substrate with a common electrode; and a liquid crystal layer that is sealed between the array substrate and the opposed substrate by means of sealing agent that seals together the peripheries of the two substrates.

US2014/265822A1 discloses an electronic device display with an opaque masking layer formed in an inactive border region. The opaque masking layer may overlap structures in the inactive border region such as the support circuitry, thereby blocking the support circuitry from view. The opaque masking layer may be formed a glass layer in the display, in part of a polarizer in a display, under a planarization layer, or between other layers in the display.

US2017/322357A1 discloses an organic light-emitting diode display which has an active area that contains pixels and an inactive area. The inactive area of the display may be provided with opaque masking layer structures having an appearance that matches the active area of the display when the pixels are off and are not displaying images.

### SUMMARY

This document describes techniques and systems for displays with passive display areas. The displays include display panel modules that define inactive display areas configured to reflect ambient light in a desired color, resulting in seamless opaque borders for electronic devices. By reflecting ambient light in a desired color in the inactive display area, the perceived color of the gap region surrounding the display can be selected to match and/or complement the color of the opaque border, providing for a seamless bezel and more-immersive user experience. In aspects, the desired color complements and/or matches the color of the opaque border, enabling the manufacture and use of display panel modules that provide an immersive user experience through the use of opaque borders in colors other than black.

The invention for which protection is sought is defined by the appended claims.

In the claimed invention, a display panel module operated in an environment with ambient light includes an active area with an array of light-emitting pixels that display an image (emit light) and an inactive area that is free of light-emitting pixels. The array of light-emitting pixels comprises an array of organic light-emitting diodes. The inactive area includes a reflective display area and a bezel area. The reflective display area is disposed between the active area and the bezel area. The bezel area includes an opaque border. The reflective display area includes a color filter that filters ambient light and a reflector that reflects filtered light. Aspects described below may include a display panel structure and a display cover layer.

The display panel structure includes a display backplane structure, which includes a substrate and backplane layers on the substrate layer that drive an array of light-emitting pixels. The array of light-emitting pixels may be disposed on (supported by) the backplane layers in the active area. The display panel structure may include an encapsulation layer encapsulating the array of light-emitting pixels on the backplane layers. The encapsulation layer prevents degradation of the array of light-emitting pixels. The display cover layer may be bonded to the display panel structure at an upper surface of the encapsulation layer.

Aspects described below may include one or more of the features defined in this paragraph. The display panel structure may further include a color filter disposed between the encapsulation layer and the display cover layer in the inactive area. The display panel structure may further include a reflector defined in the backplane layers and disposed in the inactive area. The reflector may further include a light-scattering structure disposed in the inactive area for diffusing light (*e.g*., ambient light, filtered light, reflected light). The light-scattering structure may be a surface-structure diffuser. The light-scattering structure may be disposed between the color filter and the encapsulation layer. The color filter may include integrated light-diffusing material. The display panel structure may include a touch layer disposed in the inactive area. The touch layer may be disposed between the display cover layer and the encapsulation layer. The display panel structure may include a polarizer layer in the inactive area between the display cover layer and the encapsulation layer. The opaque border may be applied to an underside of the display cover layer. The opaque border may vertically overlap *(e.g.,* in a Z-direction) at least one of the color filters or the reflector.

Aspects described below also include an electronic device including a housing and a display panel module as described herein.

This Summary is provided to introduce simplified concepts of display panel modules with passive display areas that reflect ambient light in desired colors, which are further described below in the Detailed Description and Drawings. This Summary is not intended to identify essential features of the claimed subject matter, nor is it intended for use in determining the scope of the claimed subject matter.

### BRIEF DESCRIPTION OF THE DRAWINGS

The details of one or more aspects of display panel modules (displays with passive display areas that reflect ambient light in desired colors) are described in this document with reference to the following drawings. In the drawings, the thickness and width of layers, structures, and the like may be exaggerated for clarity. The same numbers are used throughout the drawings to reference like features and components:
Fig. 1 is a top, environmental view of an electronic device having a display panel module;
Fig. 2 is a schematic view of a first display panel module having a display panel structure;
Fig. 3 is a schematic view of a second display panel module having a display panel structure;
Fig. 4 is a schematic view of a third display panel module having a display panel structure;
Fig. 5 is a schematic view of a fourth display panel module having a display panel structure;
Fig. 6 is a schematic view of a fifth display panel module having a display panel structure;
Fig. 7 is a schematic view of a sixth display panel module having a display panel structure;
Fig. 8 is a schematic view of a seventh display panel module having a display panel structure; and
Fig. 9 illustrates an example method for disguising a gap region on a display panel module to provide a seamless opaque border on an electronic device.

### DETAILED DESCRIPTION

### Overview

This document describes techniques and systems for displays with passive display areas. The displays include display panel modules that define inactive display areas configured to reflect ambient light in the desired color. Through the use of these techniques and systems, an electronic device operated in environments with ambient light can utilize a display panel module that provides a reflective display area located in an inactive (non-emissive) display area of the display panel module to provide a seamless opaque border, such as a white-colored reflective display area complementing a white-colored opaque border. In aspects, the desired color complements and/or matches the color of the opaque border, enabling the manufacture and use of a display panel modules that provide an immersive user experience through the use of opaque borders in colors other than black. The opaque border may include a gradient from opaque to transparent.

Many display panel modules for electronic devices are manufactured with a layered structure. For example, the display panel structure of a display panel module may include a display panel having light-emitting pixels, a touch layer for detecting physical touch, a polarizer layer for reducing reflections, a display cover layer, and optically clear adhesive (OCA) bonding one or more layers of the display panel structure together. Examples of display panels include active-matrix organic light-emitting diode (AMOLED) display panels, organic light-emitting diode (OLED) display panels, light-emitting diode (LED) display panels, liquid crystal display (LCD) display panels, microLED display panels, display technologies with individually-controllable pixels, thin-film technology display panels, and the like. The presently claimed invention concerns OLED display panel modules.

Display panel modules may include a display cover layer bonded to the top of the display panel structure. Before the display cover layer is bonded to the display panel structure, an opaque border (bezel) may be added to the underside of the display cover layer. The opaque border acts as a frame, hiding routing circuitry in an inactive (non-emissive) area of the display panel module. Ideally, the opaque border is wide enough to cover the entire inactive area of the display panel module. However, as a result of manufacturing tolerances present in processes utilized to laminate display cover layers to the top of the display panel structure, a gap region may exist in the inactive area between the inner edge of the opaque border and the edge of the pixels of the active area. To a user of the device, this gap region looks like a black rim that surrounds the display, located between the edge of the active display area and the edge of the opaque border. In such a configuration, a black-colored opaque border appears seamless and provides for more immersive user experience. However, if the opaque border is a color other than black when a lighter image is displayed on the display (*e.g*., display surface), the gap region is visible to the user, appearing as a black frame around the lighter-colored display, potentially preventing an immersive user experience.

In contrast, using the described techniques and systems, display panel modules (displays) for electronic devices that include passive display areas can be provided. The display panel modules may include display panel structures that define inactive display areas (*e.g.,* reflective display areas) configured to reflect ambient light in desired colors. As a result of reflecting light in the desired color in the inactive display area, the perceived color of the gap region surrounding the display can be selected to complement and/or match the color of the opaque border, thereby enabling the manufacture and use of display panel modules that provide an immersive user experience through the use of opaque borders in colors other than black.

For example, a display panel module for a mobile device (*e.g*., smartphone) can define a reflective display area located in an inactive (non-emissive) display area of the display panel module. The reflective display area may be configured to reflect light with a light blue tint that matches the light blue color of an opaque border (bezel) applied to the underside of the display cover layer. As a result, the perceived color of the gap region between the inner edge of the opaque border and the outer edge of the pixels is a similar color (light blue) to the color of the opaque border (light blue), providing for a seamless bezel on the mobile device and an improved immersive user experience.

This is merely one simple example of ways in which techniques and systems for display panel modules with passive display areas may be used, other examples and details are provided below. This document now turns to an example environment, after which example implementations are described.

### Example Environment

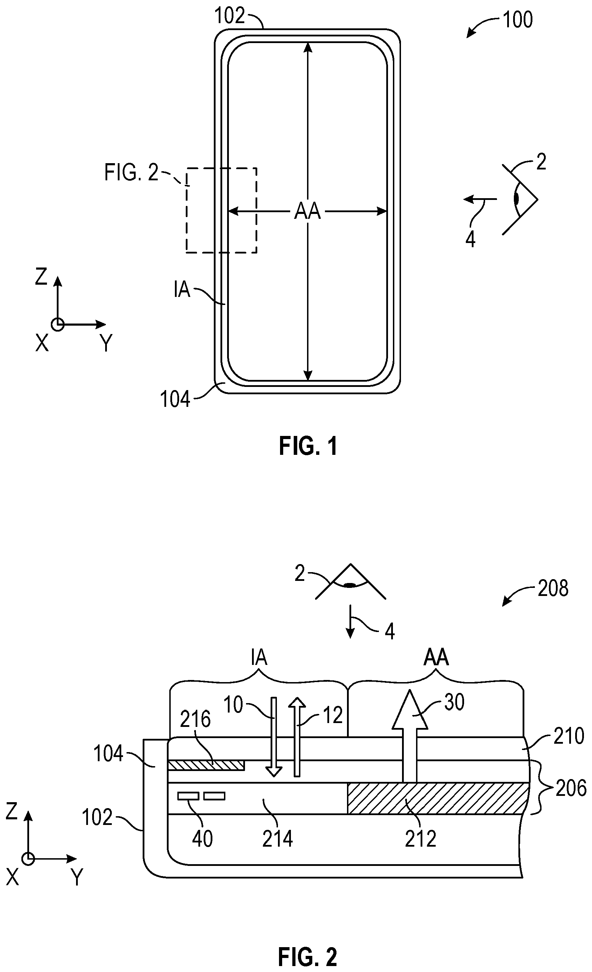

Fig. 1 illustrates an example environment 100 in which techniques and systems for display panel modules with passive display areas can be implemented. The example environment 100 illustrates an electronic device 102 viewed by a user 2 looking in a direction 4 towards the display of the electronic device 102. As further illustrated in Fig. 2, the electronic device 102 includes a housing 104 that houses a display panel module 208 that includes a display panel 206 *(e.g.,* an AMOLED display panel, a LED display panel) that generates a display. A display cover layer 210, bonded to the top of the display panel structure, protects the display panel 206 from damage. The display panel module 208 may further include one or more of a touch layer (*e.g.,* touch sensor panel) or a polarizer layer (*e.g*., polarization filter, polarizer film, circular polarizer film, circular polarizer that includes a linear polarizer and a quarter-wave retarder), not illustrated in Fig. 1 or Fig. 2.

As illustrated in Fig. 2, the display panel 206 includes an active light-emitting element 212 *(e.g.,* array of light-emitting pixels) for emitting light 30 (emitted light) in an active area (AA) of the display panel module 208. The display panel module 208 also includes a passive element 214 in an area free of light-emitting pixels. In aspects, the active light-emitting element 212 does not extend across (in the X-direction and/or the Y-direction) the entirety of the display panel 206, resulting in the definition of the active area (AA) defined above (in the Z-direction) the active light-emitting element 212 and the inactive area (IA) defined above the passive element 214. The active area can also be referred to as an emissive pixel area, and the inactive area referred to as a non-emissive area. While in Fig. 2, the display panel 206 includes the active light-emitting element 212 and the passive element 214, in other aspects, the passive element 214 may be in a separate portion of the display panel module 208 from the display panel 206.

The display cover layer 210 may be bonded to the top of the display panel structure *(e.g.,* to an upper surface of the display panel 206) through the use of an adhesive *(e.g.,* optically clear adhesive (OCA)). Before the display cover layer 210 is bonded to the display panel structure, an opaque border 216 *(e.g.,* a bezel) may be applied to the underside of the display cover layer 210, for example, in a bezel area. When bonded, the opaque border 216 is located in the inactive area (IA) and covers (*e.g*., overlaps) at least a portion of the passive element 214. In aspects, the opaque border 216 is ink applied to, deposited, or printed *(e.g.,* by photolithography, by printing) on the underside of the display cover layer 210, as illustrated in Figs. 1 and 2. The opaque border 216 acts as a frame, hiding routing circuitry 40 located in the display panel 206 and surrounding the portion of the display panel 206 visible to the user 2 of the electronic device 102, such as when the user 2 views content displayed on the active area (AA) of the display panel 206.

The passive element 214 receives ambient light 10 and transmits reflected light 12, filtered light, and/or diffused light. The passive element 214 utilizes one or more reflectors and color filters and optionally diffusers to create a passive display area (reflective display area) in the inactive area viewable by the user 2. Through the selection of the one or more reflectors and color filters, and optionally diffusers, the reflective display area *(e.g.,* the portion of the passive element 214 not covered by the opaque border 216) can be configured to transmit reflected, filtered, and/or diffused ambient light in the desired color. In aspects, the desired color complements and/or matches the color of the opaque border 216, enabling the manufacture and use of display panel modules that provide an immersive user experience through the use of opaque borders in colors other than black.

These and other capabilities and configurations are set forth in greater detail below. The example environment 100 of Fig. 1 and the detailed illustrations of Figs. 2 through Fig. 8 illustrate some of many possible environments, components, and devices capable of employing the described techniques and systems.

### Additional Example Implementations

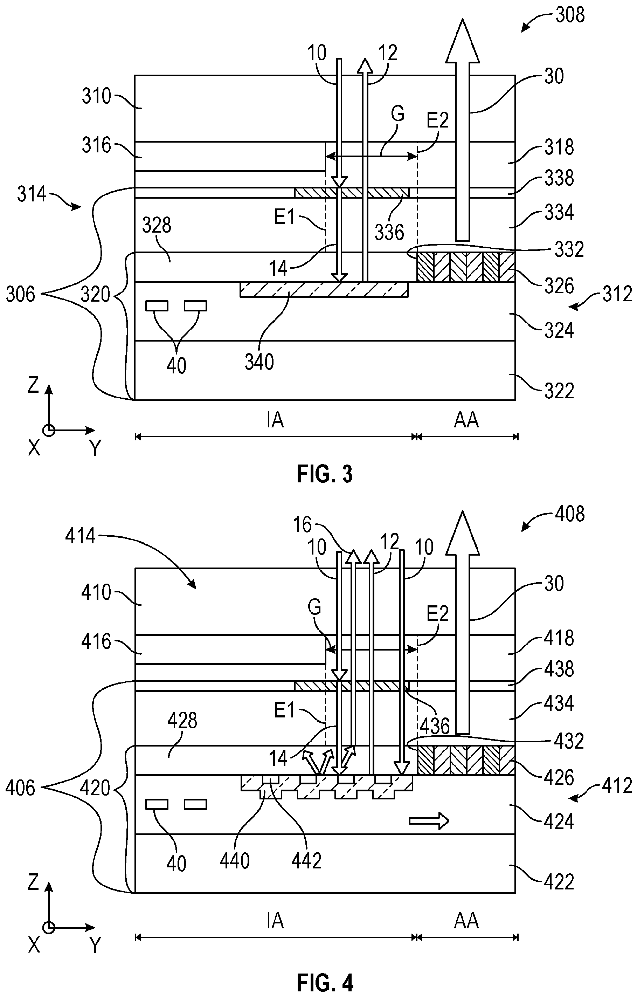

Referring now to Fig. 3, a display panel module 308 that includes a display panel 306 is illustrated. The display panel module 308 is similar to the display panel module 208 illustrated in Figs. 1 and 2, and described above, except as detailed below. The display panel module 308 may be disposed in a housing (not illustrated) of an electronic device (not illustrated), such as is illustrated with respect to the example environment 100 of Fig. 1 and the display panel module 208 of Fig. 2. The display panel 306 includes a display backplane structure 320. The display backplane structure 320 includes an active light-emitting element 312 *(e.g.,* an array of light-emitting pixels) for emitting light 30 in the active area (AA) of the display panel module 308. In the claimed invention, the display panel 306 is an OLED display panel.

The display panel module 308 also includes a passive element 314 defined in an area free of light-emitting pixels *(e.g.,* the inactive area (IA)). In aspects, such as is illustrated in Fig. 3, the active light-emitting element 312 *(e.g.,* the pixels) does not extend across (in the X-direction and/or the Y-direction) the entirety of the display panel 306. This results in the definition of an active area (AA) defined above (in the Z-direction) the active light-emitting element 312, and the definition of an inactive area (IA) above the passive element 314.

The passive element 314 receives ambient light 10 therein and uses one or more reflectors and color filters and optionally diffusers of the passive element 314 to transmit reflected light 12 from the inactive area to create a passive display (reflective display) in the inactive area viewable by the user 2 (illustrated in Fig. 2). Through the selection of the one or more reflectors and color filters, and optionally diffusers, the reflective display area *(e.g.,* the portion of the passive element not covered by the opaque border) can be configured to reflect ambient light in the desired color. In aspects, the desired color complements or matches the color of the opaque border, thereby enabling the manufacture and use of a display module that provides an immersive user experience utilizing opaque borders in colors other than black.

In the aspect illustrated in Fig. 3, the display backplane structure 320 includes a substrate 322, backplane layers 324 that drive the light-emitting pixels, and an array of light-emitting pixels 326 (pixels 326) supported by the backplane layers 324. The substrate 322 can be formed of glass, polyimide (PI), polyethylene terephthalate (PET), or another material. One or more backplane layers 324 of the display backplane structure 320 are formed (deposited) on the substrate 322. For example, the display backplane structure 320 may be disposed on the substrate *322 (e.g.,* a substrate layer). In aspects, the backplane layers 324 may be disposed with one or more other layers on the substrate 322. The backplane layers 324 *(e.g.,* thin-film transistor (TFT) array, TFT-based backplane) drives the array of light-emitting pixels 326. The backplane layers 324 may include one or more of a power source, a timing component, a set of TFT components, controllers, electrical connectors, capacitors, electrodes, data signal lines, logic circuitry, and the like. The display panel module 308 may further include one or more of a touch layer *(e.g.,* touch sensor panel) or a polarizer layer (*e.g*., polarization filter, polarizer film, circular polarizer film, circular polarizer with a linear polarizer and a quarter-wave retarder), not illustrated in Fig. 3.

The array of light-emitting pixels 326 emit light for the display of an image on a display *(e.g.,* display surface), for example, on a display screen of an electronic device *(e.g.,* the electronic device 102 of Fig. 1). The array of light-emitting pixels 326 may include one or more of an organic active layer (*e.g*., emitting layer, emissive layer, an array of organic light-emitting diodes), a cathode, and an anode. In the aspect illustrated in Fig. 3, the array of light-emitting pixels 326 are disposed in an organic active layer 328, and the array of light-emitting pixels 326 terminate at a pixel outer edge 332 and do not extend through the entire (in the Y-direction) organic active layer 328. The pixel outer edge 332 defines an edge (E2) of the active area (AA). The array of light-emitting pixels 326 is supported by the backplane layers 324. In aspects, one or more other layers may be disposed between the backplane layers 324 and the array of light-emitting pixels 326.

Fig. 3 illustrates an encapsulation layer 334 that encapsulates the array of light-emitting pixels 326 on the backplane layers 324. The encapsulation layer 334 protects and prevents the degradation of the array of light-emitting pixels 326. The encapsulation layer 334 defines an upper surface opposite the array of light-emitting pixels 326. The display cover layer 310 bonds to the display panel 306 at the upper surface of the encapsulation layer 334 through the use of the adhesive 318 *(e.g.,* optically clear adhesive (OCA)), as described with respect to Fig. 2. In aspects, one or more other layers may be disposed between the array of light-emitting pixels 326 and the encapsulation layer 334.

Before the display cover layer 310 is bonded to the display panel 306, an opaque border 316 *(e.g.,* the opaque border 216 of Fig. 2) is applied to the underside of the display cover layer 310 in a bezel area. When bonded, the opaque border 316 is located in the inactive area (IA) and covers (*e.g*., overlaps) at least a portion of the passive element 314. The opaque border 316 defines an inner edge (E1), and a gap region (G) is defined in the inactive area (IA) between the inner edge (E1) of the opaque border 316 and the edge (E2) of the pixels 326 of the active area (AA).

The passive element 314 includes at least one color filter 336 *(e.g.,* an optical filter) in the gap region (G) of the inactive area (IA). The color filter 336 may be disposed in a color filter layer 338. In the aspect illustrated in Fig. 3, the color filter 336 is disposed on the encapsulation layer 334 in the gap region of the inactive area. The color filter 336 may be deposited or patterned onto the encapsulation layer 334 or other layers of the display panel structure by an application process (*e.g*., photolithography, printing). The color filter 336 may be a single color *(e.g.,* blue, red), a combination of more than one color, or may include at least one color filter pattern *(e.g.,* red, green, and blue (RGB) color filters; cyan, magenta, and yellow (CMY) color filters). Color filter patterns can include more than one color pattern. By changing the area ratio of each color in the color filter pattern, the apparent color at the gap region can be changed. Further, in a color filter 336, the size (pitch) of each segment of color in the color filter may be the same as the neighboring pixel size. Where the neighboring pixel size is small enough *(e.g.,* more than 300 pixels per inch), the segments of color in the color filter 336 do not need to be as small as the size of the pixels 326.

The passive element 314 further includes at least one reflector 340 located within the display backplane structure 320 in the inactive area (IA) in the gap region (G). In Fig. 3, the reflector 340 is illustrated within the backplane layers 324, below the organic active layer 328. In an aspect, the reflector 340 may be located between the backplane layers 324 and the organic active layer 328. In another aspect, the reflector 340 may be located within the organic active layer 328. The reflector 340 may include a highly-reflective metal reflector. For example, the reflector 340 may be a reflective surface made using existing metal layers in the panel fabrication process, such as silver and/or aluminum.

In the aspect illustrated in Fig. 3, the passive element 314 includes a color filter 336 and a reflector 340. Together, the color filter 336 and the reflector 340 in the display panel module 308 provide a reflective display area adjacent to the emissive pixel area (active area) of the display panel 306. Ambient light 10 passing through the display cover layer 310 is received by the passive element 314. The ambient light 10 passes through the color filter 336 of the passive element 314 as filtered light 14, and the filtered light 14 is reflected by the reflector 340 back through the color filter 336 as reflected light 12. This creates a passive display (reflective display area) in the inactive area viewable by the user. By selecting an appropriate color filter and/or reflector, the reflected light 12 reflecting through the display cover layer 310 can be adjusted to desired wavelengths, for example, to match or complement the color of the opaque border 316.

In an example, the color filter 336 is a blue color filter that selectively transmits light in blue wavelengths while absorbing light in other wavelengths. As a result, only the blue light passes through the color filter 336. Ambient light 10 enters the passive element 314 through the display cover layer 310. As the ambient light 10 passes through the color filter 336 of the passive element 314, the color filter 336 absorbs light other than light in blue wavelengths. The color filter 336 transmits filtered light 14 *(e.g.,* blue light), which then passes through one or more layers of the display panel module 308 in the gap region (G) until it strikes the reflector 340. The reflector 340 reflects the filtered light 14 upwards (in the Z-direction) through the gap region as reflected light 12. The reflected light 12 passes back through the color filter 336 again and through the display cover layer 310 and is emitted from the display panel module 308. As a result, a user perceives that the gap region as having a blue color.

Referring now to Fig. 4, a display panel module 408 that includes a display panel 406 is illustrated. The display panel module 408 is similar to the display panel module 308 illustrated in Fig. 3 and described above, except as detailed below. Thus, the display panel module 408 includes display panel 406, display cover layer 410, active light-emitting element 412, passive element 414, adhesive 418, opaque border 416, display backplane structure 420, substrate 422, backplane layers 424, array of light-emitting pixels 426, organic active layer 428, pixel outer edge 432, encapsulation layer 434, color filter 436, color filter layer 438, and reflector 440. Also illustrated are emitted light 30, active area (AA), inactive area (IA), gap region (G), inner edge (E1), pixel edge (E2), ambient light 10, and filtered light 14. The display panel module 408 may further include one or more of a touch layer *(e.g.,* touch sensor panel) or a polarizer layer (*e.g*., polarization filter, polarizer film, circular polarizer film, circular polarizer with a linear polarizer and a quarter-wave retarder), not illustrated in Fig. 4.

The display panel module 408 further includes at least one light-scattering structure *(e.g.,* diffuser 442). The diffuser 442 may diffuse at least some of the filtered light 14 passing from the color filter 436 in the gap region G as diffused light 16. The diffuser 442 may diffuse at least some of the reflected light 12 reflected by the reflector 440. The reflector 440 may reflect filtered light as reflected light 12. The reflector 440 may reflect light diffused by the diffuser 442 as diffused light 16. The reflected light 12 and/or the diffused light 16 may be emitted out of the display cover layer 410.

Through the utilization of the diffuser 442, the color of the diffused light 16 transmitted from the color filter 436 and out of the display cover layer 410 is diffused and can better be matched with the color of the opaque border 416 on the display cover layer 410, for example by making the reflected light 12 appear less metallic. For example, the color of the diffused light 16 *(e.g.,* metallic reflection color) can better be matched and/or coordinated with a color of the opaque border 416 on the display cover layer 410.

In the aspect illustrated in Fig. 4, the diffuser 442 is a surface-structure diffuser integrated into the reflector 440. For example, the surface of the reflector 440 may be patterned *(e.g.,* have a rough and bumpy surface) when applied in or to backplane layers 424, resulting in the diffusion of the reflected light 16 reflected from the reflector 440. In the aspect illustrated in Fig. 4, the diffuser 442 is integrated within the reflector 440. In other aspects, the diffuser 442 may be separate from the reflector 440 and may be a different type of light-scattering structure.

In an example, the color filter 436 is a red color filter that selectively transmits light in red wavelengths while absorbing light in other wavelengths. Ambient light 10 enters the passive element 414 and passes through the color filter 436. As the light passes through the color filter 436, all light other than in light in red wavelengths is absorbed. The color filter 436 transmits red light (filtered light 14), which then passes through the layers of the display panel module 408 in the gap region until it strikes the reflector 440 and/or the diffuser 442. Some light may be reflected (in the Z-direction) by the reflector 440 as reflected light 12. Some light may be reflected by the reflector 440 and diffused by the diffuser 442 as diffused light 16, reflected back upwards (in the Z-direction) through the gap region (G). The reflected light 12 and/or the diffused light 16 passes back through the color filter 436 again, and through the display cover layer 410 and is emitted from the display panel module 408. As a result, a user perceives the gap region (G) as having a red color.

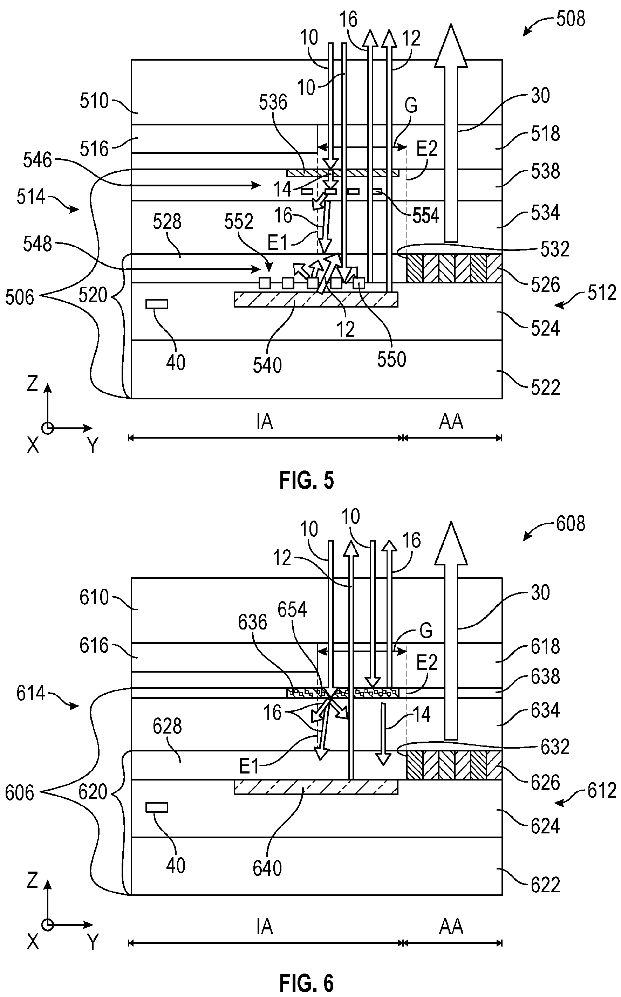

Referring now to Fig. 5, a display panel module 508 that includes a display panel 506 is illustrated. The display panel module 508 is similar to the display panel module 308 illustrated in Fig. 3 and described above, except as detailed below. Thus, the display panel module 508 includes display panel 506, display cover layer 510, active light-emitting element 512, passive element 514, adhesive 518, opaque border 516, display backplane structure 520, substrate 522, backplane layers 524, array of light-emitting pixels 526, organic active layer 528, pixel outer edge 532, encapsulation layer 534, color filter 536, color filter layer 538, and reflector 540. Also illustrated are emitted light 30, active area (AA), inactive area (IA), gap region (G), inner edge (E1), pixel edge (E2), ambient light 10, and filtered light 14.

The display panel module 508 further includes at least two light-scattering structures (*e.g*., diffusers), namely, an upper diffuser 546 and a lower diffuser 548. The lower diffuser 548 and/or the upper diffuser 546 may diffuse at least some of the filtered light 14 passing from the color filter 536 in the gap region G as diffused light 16. The lower diffuser 548 and/or the upper diffuser 546 may diffuse at least some of the reflected light 12 reflected by the reflector 540. The reflector 540 may reflect filtered light as reflected light 12. The reflector 540 may reflect light diffused by the lower diffuser 548 and/or the upper diffuser 546 *(e.g.,* diffused light 16) as diffused light 16. The reflected light 12 and/or diffused light 16 may be emitted out of the display cover layer 510.

The upper diffuser 546 may be a surface-structure diffuser where patterns of a light-diffusing material are added into one or more of the layers of the display panel module 508 between the color filter 536 and the reflector 540. The lower diffuser 548 may include patterns of light-diffusing material 550 located between the backplane layers 524 and the organic active layer 528. The patterns of light-diffusing material in one or more of the upper diffuser 546 or the lower diffuser 548 may be semi-randomized or randomized for preventing reflection artifacts, such as Moiré patterns and diffraction artifacts. The display panel module 508 may further include one or more of a touch layer *(e.g.,* touch sensor panel) or a polarizer layer *(e.g.,* polarization filter, polarizer film, circular polarizer film, circular polarizer with a linear polarizer and a quarter-wave retarder), not illustrated in Fig. 5.

Through the utilization of the upper diffuser 546 and the lower diffuser 548, the color of the diffused light 16 transmitted from the color filter 536 and out of the display cover layer 510 can better be matched with the color of the opaque border 516 on the display cover layer 510. For example, the color of the diffused light 16 *(e.g.,* metallic reflection color) can better be matched and/or coordinated with a color of the opaque border 516 on the display cover layer 510.

In an example, the color filter 536 is a light green color. As ambient light 10 passes through the color filter 536, all light other than in light in light green wavelengths is absorbed. The color filter 536 transmits light green light, which is then diffused by the upper diffuser 546. The filtered and diffused light 16 then passes through the layers of the display panel 506 of the gap region until it strikes the reflector 540. The reflector 540 reflects the light back upwards (in the Z-direction) through the gap region (G) as reflected light 12, where it contacts the lower diffuser 548, which further diffuses the light. The reflected light 12 passes back through the color filter 536 again and through the display cover layer 510. As a result, a user perceives the gap region (G) as having a light green color.

Referring now to Fig. 6, a display panel module 608 that includes a display panel 606 is illustrated. The display panel module 608 is similar to the display panel module 308 illustrated in Fig. 3 and described above, except as detailed below. Thus, the display panel module 608 includes display panel 606, display cover layer 610, active light-emitting element 612, passive element 614, adhesive 618, opaque border 616, display backplane structure 620, substrate 622, backplane layers 624, array of light-emitting pixels 626, organic active layer 628, pixel outer edge 632, encapsulation layer 634, color filter 636, color filter layer 638, and reflector 640. Also illustrated are emitted light 30, active area (AA), inactive area (IA), gap region (G), inner edge (E1), pixel edge (E2), ambient light 10, and filtered light 14. The display panel module 608 may further include one or more of a touch layer *(e.g.,* touch sensor panel) or a polarizer layer (*e.g*., polarization filter, polarizer film, circular polarizer film, circular polarizer with a linear polarizer and a quarter-wave retarder), not illustrated in Fig. 6.

The display panel module 608 further includes at least one diffuser *(e.g.,* a volume diffuser) integrated into the color filter 636. For example, the diffuser may include small reflective color particles of diffusing material 654 integrated and/or mixed into the color filter 636. The diffusing material 654 may diffuse at least some of the ambient light 10 and/or filtered light 14 passing through the color filter 636 in the gap region G, creating diffused light 16. The diffusing material 654 may diffuse at least some of the reflected light 12 reflected by the reflector 640. The reflector 640 may reflect filtered light as reflected light 12. The reflector 640 may reflect light diffused by the diffusing material 654 as diffused light 16. Through the utilization of the diffuser (*e.g*., diffusing material 654) integrated into the color filter 636, the color of the light transmitted from the color filter 636 and out of the display cover layer 610 *(e.g.,* reflected light 12, diffused light 16) can better be matched with the color of the opaque border 616 on the display cover layer 610. For example, a display panel reflection color *(e.g.,* metallic reflection color) can better be matched and/or coordinated with a color of the opaque border 616 on the display cover layer 610.

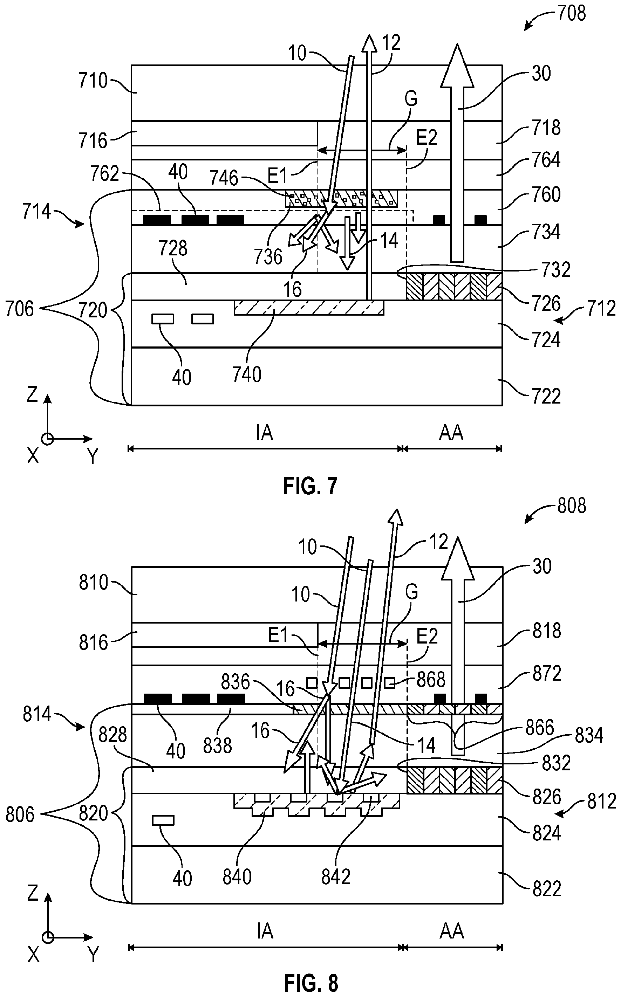

Referring now to Fig. 7, a display panel module 708 that includes a display panel 706 is illustrated. The display panel module 708 is similar to the display panel module 608 illustrated in Fig. 6, and described above, except as detailed below. Thus, the display panel module 708 includes display panel 706, display cover layer 710, active light-emitting element 712, passive element 714, adhesive 718, opaque border 716, display backplane structure 720, substrate 722, backplane layers 724, array of light-emitting pixels 726, organic active layer 728, pixel outer edge 732, encapsulation layer 734, color filter 736, color filter layer, and reflector 740. Also illustrated are emitted light 30, active area (AA), inactive area (IA), gap region (G), inner edge (E1), pixel edge (E2), ambient light 10, reflected light 12, filtered light 14, and diffused light 16.

The display panel module 708 includes one or more touch layers (*e.g*., touch sensor panel), for example, touch layer 760. The touch layer 760 detects physical touch to the display panel.

The display panel module 708 may further include one or more polarizer layers (*e.g*., polarization filter, polarizer film, circular polarizer film, circular polarizer with a linear polarizer and a quarter-wave retarder), for example, polarizer layer 764. The polarizer layer 764 is configured to reduce reflections on the display surface of the display panel module. In aspects, the polarizer layer 764 is a circular polarizer film that includes a linear polarizing film and a quarter-wave plate (QWP), which together minimize the reflection of ambient light from structures and/or patterns (*e.g*., silver patterns) within the display panel module. In other aspects, the display panel module 708 may further include a quarter-wave plate layer 762 (QWP layer 762), for example, within the touch layer 760. The QWP layer 762 *(e.g.,* retarder layer, QWP coating) may be utilized for mitigating the reflection reduction effect of the polarizer layer 764 in the gap region (G). The QWP layer 762 can be deposited between the polarizer layer 764 *(e.g.,* polarizer film) and the reflector 740 within the gap region (G), for example, deposited or patterned onto the encapsulation layer 734 by an application process (*e.g*., photolithography, printing).

In the aspect illustrated in Fig. 7, the touch layer 760 is located above (in the Z-direction) the encapsulation layer 734, the color filter 736 is applied on or is embedded within the touch layer 760, and the polarizer layer 764 is disposed on the touch layer 760. In other aspects, the touch layer 760, the polarizer layer 764, and the other layers may be present in the display panel module 708 in a different order in the Z-direction.

The display panel module 708 may further include a diffuser *(e.g.,* a volume diffuser), for example, integrated into the color filter 736. For example, the diffuser may include small reflective color particles of diffusing material 746 integrated and/or mixed into the color filter 736. The diffusing material 746 diffuses some of the ambient light 10 passing through the color filter 736 in the gap region G, creating diffused light 16. The diffused 16 then passes through one or more of the layers of the display panel 706 in the gap region (G) until it strikes the reflector 740. The reflector 740 reflects the light *(e.g.,* reflected light 12) upwards (in the Z-direction), where it passes through the color filter 736 again, through the gap (G), and exits the display cover layer 710. Through the utilization of the diffuser (*e.g*., diffusing material 746) integrated into the color filter 736, the color of the light transmitted from the color filter 736 and out of the display cover layer 710 can better be matched with the color of the opaque border 716 on the display cover layer 710. For example, a display panel reflection color *(e.g.,* metallic reflection color) can better be matched and/or coordinated with a color of the opaque border 716 on the display cover layer 710.

Referring now to Fig. 8, a display panel module 808 that includes a display panel 806 is illustrated. The display panel module 808 is similar to the display panel module 608 illustrated in Fig. 6, and described above, except as detailed below. Thus, the display panel module 808 includes display panel 806, display cover layer 810, active light-emitting element 812, passive element 814, adhesive 818, opaque border 816, display backplane structure 820, substrate 822, backplane layers 824, array of light-emitting pixels 826, organic active layer 828, pixel outer edge 832, encapsulation layer 834, color filter 836, color filter layer 838, reflector 840, and diffuser. Also illustrated are emitted light 30, active area (AA), inactive area (IA), gap region (G), inner edge (E1), pixel edge (E2), ambient light 10, reflected light 12, filtered light 14, and diffused light 16.

The display panel module 808 may include one or more of a touch layer *(e.g.,* touch sensor panel), not illustrated in Fig. 8. In the aspect illustrated in Fig. 8, the color filter 836 can be utilized as an alternative to the use of a polarizer layer. In aspects, the color filter 836 can be formed when a color filter array 866 (CFA 866) is applied above the pixels of the emitting layer (the pixels of the array of light-emitting pixels 826), for example by utilizing a color filter and black mask process (*e.g*., RGB color mask process) to reduce reflections from the pixels on the display surface of the display panel module. The color filter array 866 may include color filters aligned with the pixels, and that matches the colors of the pixels.

The display panel module 808 may also include a diffuser (*e.g*., diffusing material 868) in the touch sensor layer 872 and a surface-structure diffuser 842 integrated into the reflector 840, as described with respect to Fig. 4, for scattering/diffusing the reflected light 12, filtered light 14, and/or diffused light 16 transmitted from the panel gap region (G) to match the tone and/or color of the opaque border 816.

In an example, ambient light 10 enters the display panel 806 through the display cover layer 810. Some of the ambient light 10 may be diffused by a light-diffusing structure, for example, diffusing material 868, resulting in diffused light 16. The diffused light 16 and undiffused ambient light 10 are received into the color filter 836. In this example, the color filter 836 is a magenta color filter that selectively transmits light in magenta-colored wavelengths while absorbing light in other wavelengths. As a result, only magenta-colored light passes through the color filter 836. As the diffused light 16 and undiffused ambient light 10 pass through the color filter 836, all light other than light in magenta-colored wavelengths is absorbed. The color filter 836 transmits filtered light 14 (magenta light), which then passes through one or more of the layers of the display panel 806 in the gap region (G) until it strikes the reflector 840. The reflector 840 may further include a light-scattering structure (*e.g*., diffuser), for example, a surface-structure diffuser 842 integrated into the reflector 840, as described with respect to Fig. 4. The reflector 840 reflects the filtered light and diffused light upwards (in the Z-direction) through the gap region as reflected light 12. The reflected light 12 passes back through the color filter 836 again and through the display cover layer 810. As a result, a user perceives the gap region as having a magenta color.

One or more of the techniques described above with respect to Figs. 1-8 can be combined together to form a display panel module that creates the desired tone and/or color of reflected light in the gap region similar or complementary to the color of the opaque border. One or more of the techniques described above with respect to Figs. 1-8 can be combined together to form a display panel that creates the desired tone and/or color of reflected light in the gap region similar or complementary to the color of the opaque border. In aspects, the techniques and systems for displays with passive display areas include an electronic device having a housing that houses a display panel.

### Example Methods

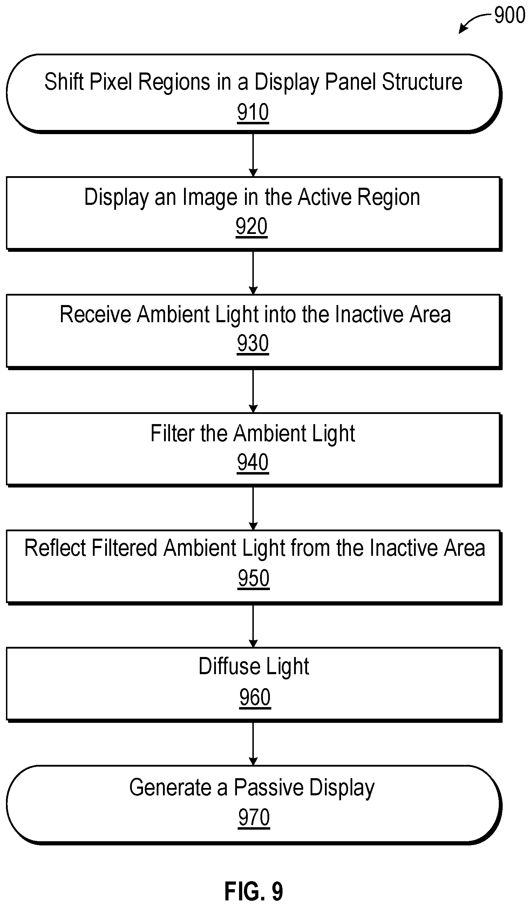

This section describes example methods, which may operate separately or together in whole or in part. Fig. 9 illustrates an example method 900 for disguising a gap region on a display panel to provide a seamless opaque border on an electronic device. Method 900 is illustrated as a set of blocks that specify operations performed but are not necessarily limited to the order or combinations shown for performing the operations by the respective blocks. Further, any of one or more of the operations may be repeated, combined, reorganized, or linked to provide a wide array of additional and/or alternate methods. In portions of the following discussion, reference may be made to the example environment 100 of Fig. 1 or to entities or processes as detailed in other figures, reference to which is made for example only. The techniques are not limited to performance by one entity or multiple entities operating on one device.

At 910, pixel regions in a display panel module are shifted to define an active area that includes an array of light-emitting pixels configured to emit light and an inactive area that is free of light-emitting pixels. At 920, an image emitted from the array of light-emitting pixels is displayed in the inactive region. At 930, ambient light is received into the inactive area. At 940, the ambient light is filtered, for example, by a color filter. At 950, filtered light is reflected from the inactive area to, at 970, generate a passive display. In aspects, at 960, at least one of the ambient light, the filtered light, or the reflected light is diffused before it is reflected from the inactive area.

### Conclusion

Although implementations of techniques and systems for display panels and display panel modules with passive display areas have been described in language specific to techniques and/or systems, it is to be understood that the subject of the appended claims is not necessarily limited to the specific features described. Rather, the specific features are disclosed as example implementations enabling display panels and display panel modules to provide inactive display areas that reflect ambient light in desired colors.

## Claims

1. A display panel module (308) configured to operate in an environment with ambient light (10), the display panel module comprising:
an active area (AA) with an array of light-emitting pixels (312) configured to emit light (30); and
an inactive area (IA) that is free of light-emitting pixels, the inactive area comprising a reflective display area and a bezel area, the reflective display area disposed between the active area and the bezel area in a gap region (G),
wherein the bezel area comprises an opaque border (316), and
wherein the reflective display area comprises:
a color filter (336) configured for filtering the ambient light; and
a reflector (340) configured for reflecting filtered light (14) from the gap region; and
wherein the array of light-emitting pixels comprises an array of organic light-emitting diodes.

2. The display panel module of claim 1, further comprising a display panel (306), the display panel comprising:
a display backplane structure (320) including:
a substrate layer (322);
a backplane layer (324) on the substrate layer; and
the array of light-emitting pixels (312), the array of light-emitting pixels on the backplane layer in the active area, the array of light-emitting pixels driven by the backplane layer.

3. The display panel module of claim 2, further comprising:
an encapsulation layer encapsulating the array of light-emitting pixels on the backplane layer, the encapsulation layer defining an upper surface opposite the array of light-emitting pixels; and
a display cover layer, wherein the display cover layer is bonded to the upper surface of the encapsulation layer.

4. The display panel module of claim 3, further comprising the color filter disposed between the encapsulation layer and the display cover layer in the inactive area.

5. The display panel module of any of claims 2 through 4, further comprising the reflector defined in the backplane layer, and the reflector disposed in the inactive area.

6. The display panel module of any preceding claim, further comprising a light-scattering structure disposed in the inactive area, the light-scattering structure configured for diffusing light.

7. The display panel module of claim 6, wherein the light-scattering structure comprises a surface-structure diffuser.

8. The display panel module of claim 6 or 7, further comprising the light-scattering structure disposed between the color filter and the encapsulation layer.

9. The display panel module of any preceding claim, wherein the color filter further comprises a light-diffusing material integrated into the color filter.

10. The display panel module of any preceding claim, further comprising a touch layer disposed in the inactive area.

11. The display panel module of claim 10, wherein the touch layer is disposed between the display cover layer and the encapsulation layer.

12. The display panel module of claim 3, or any preceding claim depending from claim 3, further comprising a polarizer layer disposed in the inactive area between the display cover layer and the encapsulation layer.

13. The display panel module of claim 3, or any preceding claim depending from claim 3, wherein the opaque border is applied to an underside of the display cover layer.

14. The display panel module of any preceding claim, wherein the opaque border overlaps at least one of the color filter or the reflector.

15. An electronic device comprising a housing and the display panel module of any preceding claim mounted to the housing.

## Patentansprüche

1. Anzeigepanelmodul (308), das dazu konfiguriert ist, in einer Umgebung mit Umgebungslicht (10) zu arbeiten, wobei das Anzeigepanelmodul Folgendes umfasst:
einen aktiven Bereich (AA) mit einer Anordnung von lichtemittierenden Pixeln (312), die dazu konfiguriert sind, Licht (30) zu emittieren; und
einen inaktiven Bereich (IA), der frei von lichtemittierenden Pixeln ist, wobei der inaktive Bereich einen reflektierenden Anzeigebereich und einen Einfassungsbereich umfasst, wobei der reflektierende Anzeigebereich zwischen dem aktiven Bereich und dem Einfassungsbereich in einer Lückenregion (G) angeordnet ist, wobei der Einfassungsbereich einen undurchsichtigen Rand (316) umfasst und
wobei der reflektierende Anzeigebereich Folgendes umfasst:
einen Farbfilter (336), der dazu konfiguriert ist, das Umgebungslicht zu filtern; und
einen Reflektor (340), der dazu konfiguriert ist, gefiltertes Licht (14) aus der Lückenregion zu reflektieren; und
wobei die Anordnung von lichtemittierenden Pixeln eine Anordnung von organischen Leuchtdioden (organic light-emitting diodes, OLED) umfasst.

2. Anzeigepanelmodul nach Anspruch 1, ferner umfassend ein Anzeigepanel (306), wobei das Anzeigepanel Folgendes umfasst:
eine Anzeige-Backplane-Struktur (320), die Folgendes beinhaltet:
eine Substratschicht (322);
eine Backplane-Schicht (324) auf der Substratschicht; und
die Anordnung der lichtemittierenden Pixel (312), die Anordnung der lichtemittierenden Pixel auf der Backplane-Schicht im aktiven Bereich, die Anordnung der lichtemittierenden Pixel, die von der Backplane-Schicht angesteuert wird.

3. Anzeigepanelmodul nach Anspruch 2, ferner umfassend:
eine Verkapselungsschicht, die die Anordnung von lichtemittierenden Pixeln auf der Backplane-Schicht einkapselt, wobei die Verkapselungsschicht eine obere Fläche gegenüber der Anordnung von lichtemittierenden Pixeln definiert; und
eine Anzeigedeckschicht, wobei die Anzeigedeckschicht mit der oberen Fläche der Verkapselungsschicht verbunden ist.

4. Anzeigepanelmodul nach Anspruch 3, ferner umfassend den Farbfilter, der zwischen der Verkapselungsschicht und der Anzeigedeckschicht in dem inaktiven Bereich angeordnet ist.

5. Anzeigepanelmodul nach einem der Ansprüche 2 bis 4, ferner umfassend den Reflektor, der in der Backplane-Schicht definiert ist, und den Reflektor, der in dem inaktiven Bereich angeordnet ist.

6. Anzeigepanelmodul nach einem der vorhergehenden Ansprüche, ferner umfassend eine lichtstreuende Struktur, die in dem inaktiven Bereich angeordnet ist, wobei die lichtstreuende Struktur dazu konfiguriert ist, Licht zu streuen.

7. Anzeigepanelmodul nach Anspruch 6, wobei die lichtstreuende Struktur einen Flächenstrukturdiffusor umfasst.

8. Anzeigepanelmodul nach Anspruch 6 oder 7, ferner umfassend die lichtstreuende Struktur, die zwischen dem Farbfilter und der Verkapselungsschicht angeordnet ist.

9. Anzeigepanelmodul nach einem der vorhergehenden Ansprüche, wobei der Farbfilter ferner ein lichtstreuendes Material umfasst, das in den Farbfilter integriert ist.

10. Anzeigepanelmodul nach einem der vorhergehenden Ansprüche, ferner umfassend eine Berührungsschicht, die in dem inaktiven Bereich angeordnet ist.

11. Anzeigepanelmodul nach Anspruch 10, wobei die Berührungsschicht zwischen der Anzeigedeckschicht und der Verkapselungsschicht angeordnet ist.

12. Anzeigepanelmodul nach Anspruch 3 oder einem der vorhergehenden Ansprüche, ferner umfassend eine Polarisatorschicht, die in dem inaktiven Bereich zwischen der Anzeigedeckschicht und der Verkapselungsschicht angeordnet ist.

13. Anzeigepanelmodul nach Anspruch 3 oder einem der vorhergehenden Ansprüche, die von Anspruch 3 abhängen, wobei der undurchsichtige Rand auf der Unterseite der Anzeigedeckschicht angebracht ist.

14. Anzeigepanelmodul nach einem der vorhergehenden Ansprüche, wobei sich der undurchsichtige Rand mit mindestens einem der Farbfilter oder dem Reflektor überlappt.

15. Elektronische Vorrichtung, umfassend ein Gehäuse und das an dem Gehäuse montierte Anzeigepanelmodul nach einem der vorhergehenden Ansprüche.

## Revendications

1. Module de panneau d'affichage (308) configuré pour fonctionner dans un environnement avec lumière ambiante (10), le module de panneau d'affichage comprenant :
une zone active (AA) avec un réseau de pixels électroluminescents (312) configurés pour émettre de la lumière (30) ; et
une zone inactive (IA) qui est exempte de pixels électroluminescents, la zone inactive comprenant une zone d'affichage réfléchissante et une zone de cadre, la zone d'affichage réfléchissante étant disposée entre la zone active et la zone de cadre dans une région d'espace (G),
dans lequel la zone de cadre comprend une bordure opaque (316), et
dans lequel la zone d'affichage réfléchissante comprend :
un filtre de couleur (336) configuré pour filtrer la lumière ambiante ; et
un réflecteur (340) configuré pour réfléchir la lumière filtrée (14) provenant de la zone d'espace ; et
dans lequel le réseau de pixels électroluminescents comprend un réseau de diodes électroluminescentes organiques.

2. Module de panneau d'affichage selon la revendication 1, comprenant également un panneau d'affichage (306), le panneau d'affichage comprenant :
une structure de fond de panier d'affichage (320) comportant :
une couche de substrat (322) ;
une couche de fond de panier (324) sur la couche de substrat ; et
le réseau de pixels électroluminescents (312), le réseau de pixels électroluminescents sur la couche de fond de panier dans la zone active, le réseau de pixels électroluminescents étant piloté par la couche de fond de panier.

3. Module de panneau d'affichage selon la revendication 2, comprenant également :
une couche d'encapsulation encapsulant le réseau de pixels électroluminescents sur la couche de fond de panier, la couche d'encapsulation définissant une surface supérieure opposée au réseau de pixels électroluminescents ; et
une couche de recouvrement d'affichage, dans lequel la couche de recouvrement d'affichage est collée à la surface supérieure de la couche d'encapsulation.

4. Module de panneau d'affichage selon la revendication 3, comprenant également le filtre de couleur disposé entre la couche d'encapsulation et la couche de recouvrement d'affichage dans la zone inactive.

5. Module de panneau d'affichage selon l'une quelconque des revendications 2 à 4, comprenant également le réflecteur défini dans la couche de fond de panier, et le réflecteur disposé dans la zone inactive.

6. Module de panneau d'affichage selon une quelconque revendication précédente, comprenant également une structure de diffusion de la lumière disposée dans la zone inactive, la structure de diffusion de la lumière étant configurée pour diffuser de la lumière.

7. Module de panneau d'affichage selon la revendication 6, dans lequel la structure de diffusion de la lumière comprend un diffuseur à structure de surface.

8. Module de panneau d'affichage selon la revendication 6 ou 7, comprenant également la structure de diffusion de la lumière disposée entre le filtre de couleur et la couche d'encapsulation.

9. Module de panneau d'affichage selon une quelconque revendication précédente, dans lequel le filtre de couleur comprend également un matériau de diffusion de la lumière intégré au filtre de couleur.

10. Module de panneau d'affichage selon une quelconque revendication précédente, comprenant également une couche tactile disposée dans la zone inactive.

11. Module de panneau d'affichage selon la revendication 10, dans lequel la couche tactile est disposée entre la couche de recouvrement d'affichage et la couche d'encapsulation.

12. Module de panneau d'affichage selon la revendication 3, ou une quelconque revendication précédente dépendant de la revendication 3, comprenant également une couche de polarisation disposée dans la zone inactive entre la couche de recouvrement d'affichage et la couche d'encapsulation.

13. Module de panneau d'affichage selon la revendication 3, ou une quelconque revendication précédente dépendant de la revendication 3, dans lequel la bordure opaque est appliquée sur une face inférieure de la couche de recouvrement d'affichage.

14. Module de panneau d'affichage selon une quelconque revendication précédente, dans lequel la bordure opaque chevauche au moins l'un du filtre de couleur ou du réflecteur.

15. Dispositif électronique comprenant un boîtier et le module de panneau d'affichage selon une quelconque revendication précédente monté sur le boîtier.
